# EUROPÄISCHE PATENTSCHRIFT

(11) **EP 1 084 283 B1**
(45) Veröffentlichungstag und Bekanntmachung des Hinweises auf die Patenterteilung: **17.03.2004**
(21) Anmeldenummer: 99907227.5
(22) Anmeldetag: 25.03.1999
(51) Int. Cl.: C23C 14/56, C23C 16/54, B01J 3/03, F16J 15/16

(54) **VAKUUMBANDBESCHICHTUNGSANLAGE**
VACUUM STRIP COATING INSTALLATION
INSTALLATION DE COUCHAGE SUR BANDE SOUS VIDE

(30) Priorität: 27.03.1998 CH 73898
(43) Veröffentlichungstag der Anmeldung: 21.03.2001
(73) Patentinhaber: Eidgenössische Materialprüfungs- und Forschungsanstalt EMPA, 9014 St. Gallen (CH)
(72) Erfinder: MOSER, Eva, Maria, CH-8122 Binz (CH); FEUSI, Christoph, CH-8600 Dübendorf (CH)
(74) Vertreter: Patentanwälte Breiter + Wiedmer AG
(86) Internationale Anmeldenummer: PCT/CH1999/000127
(87) Internationale Veröffentlichungsnummer: WO 1999/050472

(56) Entgegenhaltungen:
- EP-A- 0 291 952
- EP-A- 0 535 439
- US-A- 3 351 348
- US-A- 4 501 428
- US-A- 4 649 860

## Beschreibung

Die vorliegende Erfindung betrifft eine Vakuumbehandlungsanlage nach dem Oberbegriff von Patentanspruch 1. Weiter bezieht sich die Erfindung auf die Verwendung der Anlage.

Das Oberflächenbehandeln, wie z.B. das Oberflächenreinigen, -bearbeiten, aktivieren oder -beschichten, von Bandmaterialien, wie Kunststoffbahnen, Polymervliese, Papierbahnen etc., wozu ein Vakuumprozess notwendig ist, erfolgt in der Regel in Anlagen, umfassend eine einzige Kammer.

Im Artikel der Autoren J.D. Affinito et al., "A new method for fabricating transparent barrier layers", Thin Solid Films 290 - 291 (1996), Seiten 63 - 67, wird eine derartige Anlage beschrieben, wobei sowohl die Vorrats- wie auch die

Wickeltrommel für das behandelte Material zusammen mit einer Reaküonstrommel in einer einzigen Vakuumkammer angeordnet sind. Entlang einer Reaktionstrommel sind eine Reihe von Reaktionsanordnungen vorgesehen für das Durchführen von Plasma- bzw. Abscheideprozessen, beispielsweise an bzw. auf einem Polymerband, wie beispielsweise das Erzeugen einer transparenten Sperrschicht auf einer Verpackungsfolie.

Der Nachteil dieser Anlage besteht darin, dass die Prozessgase in der ganzen Anlage bzw. Kammer verteilt werden und diese so unerwünschterweise kontaminieren könnten. Nachteilig kann auch sein, dass zum Auswechseln der Vorrats- bzw. Wickelwalzen die ganze Anlage geöffnet werden muss, d.h. ebenfalls der "Reaktionsraum".

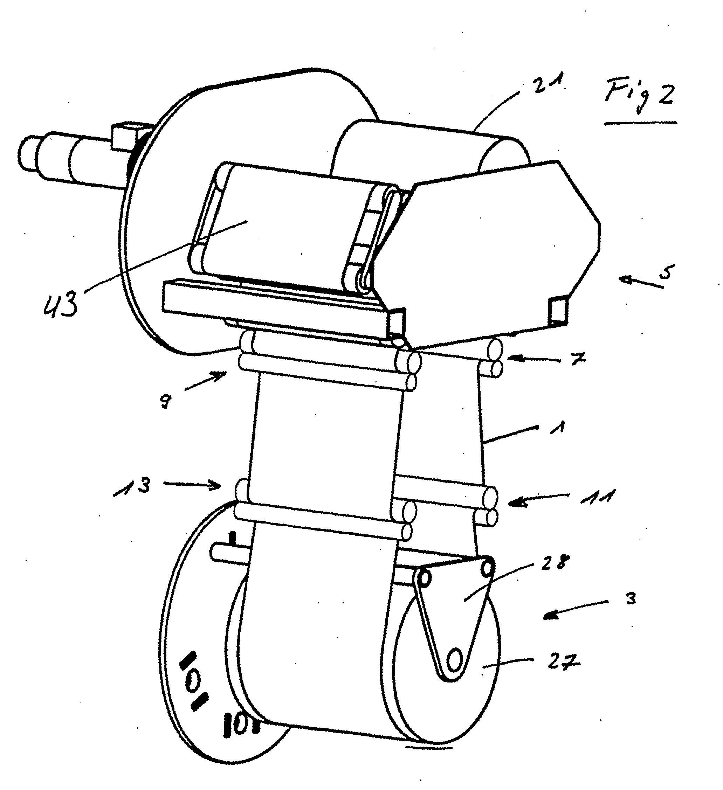

Demgegenüber wurde anlässlich des 8. Int. Techtextil-Symposiums vom 12. - 14. Mai 1997 in Stuttgart (Vortragstitel Nr. 521, Dr. M. Müller, FhIGB Stuttgart) eine Laboranlage vorgestellt für das halbkontinuierliche Plasmapfropfen der Oberflächen von bahnförmigen Materialien von Rolle zu Rolle (Abbildung 2). Dabei wird die zu behandelnde Bahnware von einer Vorratskammer über eine Schleusenkammer einer ersten Reaktionskammer zugeführt. Von dieser gelangt das bandförmige Material über eine weitere Schleuse in eine zweite Reaktionskammer und schliesslich wieder über eine Schleusenkammer in einen abschliessenden Wickelraum. Diese längsaneinandergereihte Kammeranordnung lässt wohl ein Trennen von verschiedenen Behandlungsvorgängen zu, und auch können sowohl die unbehandelte Ware wie die behandelte Ware in bzw. aus der Anlage eingeführt bzw. entnommen werden, ohne dass die Reaktionskammern zu öffnen sind.

Ein Nachteil dieses Anlagekonzeptes liegt jedoch einerseits darin, dass ein dichtes Trennen der Atmosphäre bzw. ein Drukkunterschied zwischen den einzelnen Kammern, insbesondere bei hohen Bandgeschwindigkeiten voneinander unmöglich ist und zudem die Anlage zu voluminös ist bzw. einen langen Bearbeitungsweg aufweist, insbesondere dann, wenn mehrere Behandlungsprozesse möglich sein sollen.

Die EP-A-0291952 offenbart einen Düferentialdrudcdichtungsapparat, welcher verschiedene Kammern mit sukzessiv abnehmendem oder zunehmendern Druck aufweist. Die einzelnen Kammern sind im wesentlichen U-förmig ausgebildet, mit auf der geschlossenen Seite abgedichtetem Durchtritt für das durchlaufende Band. Die einzelnen Kammern können also nicht als Schleusen bezeichnet werden.

Eine kontinuierliche Vakuumbehandlungsanlage gemäss der US-A-4501428 dient der Behandlung von weichem Material, insbesondere von Kimststoffbändem in einer Vakuumkammer. Dieser Kammer sind Hilfsvakuumkammern vorund nachgeschaltet, weiche für einen kontinuierlichen Druckabfall bzw. Druckanstieg ausgestattet sind. In den Kammern ist jeweils ein Walzenpaar für die Aufnahme des Kunststoffbandes angeordnet. Die Walzen selbst sind mit Dichtungslippen abgedichtet. Am Übergang zwischen den Kammern findet keine Dichtung statt, es kann also auch hier nicht von Schleusen gesprochen werden. Nach einer speziellen Ausführungform werden Abdichtungen für die Stirnseiten der Walzen gezeigt.

Nach der US-A-4649860 wird in einer Vakuumverdampfungsanlage die Verdampfung eines Metalls und dessen Niederschlagung auf ein Metallband, insbesondere ein Stahlband, offenbart. In der Vakuumverdampfungskammer wird das Stahlband um eine Walze grossen Durchmessers umgelenkt. Im Bereich des Scheitels wird Metall auf das kontinuierlich durchgeführte Metallband aufgedampft. Dieser Vakuumverdampfungsanlage sind mehrere einseitig abgedichtete Kammern vorgeschaltet, die jeweils individuell evakuiert werden.

Die US-A-3351348 zeigt eine Vakuummetallisierungskammer mit einer vorgeschalteten Abdichtungskammer. In diese wird unter Druck ein inertes Gas eingeleitet. Die Abdichtungskammer ist gegen die Atmosphäre mit einem Walzenpaar abgedichtet, gegenüber der Vakuumkammer mit einem endlos umlaufenden Band, weiches das zu beschichtende Band auf die Trennwand drückt und durch einen Schlitz in die Vakuumkammer führt. Wesentlich ist diese zweitgenannte Abdichtung.

Es ist daher eine Aufgabe der vorliegenden Erfindung, eine Vakuumbehandlungsanlage zu schaffen, in welcher die Vorrats- und Wickelkammer mit einer ausreichenden Abdichtung von der Reaktionskammer getrennt wird, damit einerseits der Druckunterschied zwischen den Kammern aufrechterhalten und anderseits ein Gasaustausch zwischen den Kammern verhindert werden kann.

Erfindungsgemäss wird eine Vorrichtung gemäss dem Wortlaut nach Anspruch 1 vorgeschlagen.

Die Anlage zum Oberflächenbehandeln, wie Reinigen, Beschichten, Bearbeiten, Aktivieren, Modifizieren von flächigen, längsausgedehnten Substratbahnen weist mindestens eine evakuierbare Reaktionskammer auf sowie mindestens eine der Reaktionskammer vorgeschaltete und nachgeschaltete Schleusenkammer bzw. Präparationskammer, durch welche hindurch das flächige Substrat führbar ist.

Je nach Bedarf ist eine der beiden Schleusenkammern oder sind beide evakuierbar.

Weiter umfasst die Anlage mindestens eine Vorrats- und Wickelkammer, vorgesehen für die Aufnahme der unbehandelten Substratbahn und der behandelten Substratbahn, aus welcher Vorrats- und Wickelkammer das Substrat zunächst einer Schleusenkammer mit Walzendichtungen zuführbar ist, oder in weiche Vorrats- und Wickelkammer die Substratbahn aus der Reaktionskammer oder von einer Schleusenkammer mit Walzendichtungen aufnehmbar ist. Selbstverständlich kann die Wickelvorrichtung auch in einer separaten Aufwickelkammer und Abwickelkammer untergebracht werden.

In der Reaktionskammer ist mindestens eine Bearbeitungswalze bzw. -trommel vorgesehen.

Eine oder mehrere Einrichtung(en) dienen dem Modifizieren, Beschichten, Behandeln oder Bearbeiten der Substratoberfläche. Der Reaktionsraum, eine Vakuumkammer, typische Beispiele der einen oder der mehreren Bearbeitungs- bzw. Beschichtungs- oder Behandlungseinrichtung(en) sind in der nachfolgenden Liste angegeben:
- DC-Magnetronzerstäubungsquelle, kontinuierlich und/oder gepulst;
- HF-Magnetronzerstäubungsquelle, kontinuierlich und/oder gepulst;
- Gleichstromentladung, kontinuierlich und/oder gepulst;
- Niederfrequenz-Entladung resp. Tieffrequenz, kontinuierlich und/oder gepulst;
- Hochfrequenz-Entladung, kontinuierlich und/oder gepulst;
- Mikrowellen mit und ohne Magnetfeldunterstützung, kontinuierlich und/oder gepulst;
- Radikaigenerator, kontinuierlich und/oder gepulst;
- Elektronenstrahlquelle, kontinuierlich und/oder gepulst;
- Ionenstrahlquelle, kontinuierlich und/oder gepulst, und/oder
- Elektronenstrahl- oder Laser-unterstützte Plasmaquelle, kontinuierlich und/oder gepulst.
- Prinzipiell kann jede Anregungsquelle mit elektrischen Gleichspannungsund/oder Wechselspannungsfeldern von 10 kHz bis 20 GHz eingesetzt und entsprechend kombiniert werden.

Die Substrattrommel kann gekühlt und geheizt werden (-20° C bis +100°C) und ist geerdet oder kann mit einem Bias (Hochfrequenz, Tieffrequenz oder Gleichstrom) versehen werden.

Weitere bevorzugte Ausführungsvarianten der erfindungsgemässen Vorrichtung sind in den abhängigen Ansprüchen charakterisiert.

In einem Verfahren zur Oberflächenbehandlung und/oder -beschichtung wird die flächige, längsausgedehnte Substratbahn zunächst aus einer Wickel- und Vorratskammer über eine Walzendichtung durch eine Schleusenkammer hindurch erneut über eine Walzendichtung einer Reaktionskammer zugeführt, in welcher die Behandlung bzw. Beschichtung des Substrates erfolgt. Ober diese Trommel quasi umgelenkt wird das Substrat nahe dem Bereich des Einführens wieder aus dem Reaktionsraum erneut über eine Walzendichtung entfernt, erneut durch eine Schleusenkammer geführt und durch eine Walzendichtung in die Wickel- und Vorratskammer zurückgeführt und auf einer entsprechenden Trommel aufgewickelt.

Je nach Bedürfnissen ist es möglich, in der der Reaktionskammer vorgeschalteten Schleusenkammer oder der nachgeschalteten Schleusenkammer das unbehandelte bzw. das behandelte Substrat einer Vorbehandlung bzw. einer Nachbehandlung zu unterziehen, wie beispielsweise Trocknen, Reinigen, Aktivieren, Beschichten, Modifizieren, Plasmapfropfen, mechanisch und/oder chemisch Bearbeiten, Fixieren und dergleichen.

Die erfindungsgemässe Verwendung der Erfindung liegt in der Oberflächenbehandlung und/oder -beschichtung von Verpackungsmaterialien, insbesondere für Lebensmittel, Medikamente, Tabak und

Elektronikkomponenten.

Weiter kann die erfindungsgemässe Vakuumbehandlungsanlage für die Durchführung einer oder mehrerer Oberflächenbehandlungen, wie Reinigung, Aktivieren, Beschichten, mechanisches oder chemisches Bearbeiten, Oberflächenausrüsten von flächigen Substraten verwendet werden. Das flächige Substrat besteht beispielsweise aus einem Polymer, Metall, Papier, etc. oder aus kombinierten Werkstoffen, wie insbesondere Kompositwerkstoffen bzw. mehrlagigen Werkstoffen.

Die Erfindung wird nun anschliessend beispielsweise und unter Bezug auf die beigefügten Figuren näher erläutert.

Dabei zeigen schematisch:
- Fig. 1: eine Vakuumbehandlungsanlage,
- Fig. 2: die Anlage aus Fig. 1 in perspektivischer Ansicht,
- Fig. 3: eine Anlage gemäss Fig. 1 mit Schleusenkammern,
- Fig. 4a, 4b: zwei Ausführungsvarianten einer Walzendichtung,
- Fig. 5: eine praxisorientierte Vakuumbehandlungsanlage, und
- Fig. 6: eine Vakuumbehandlungsanlage in Modulbauweise.

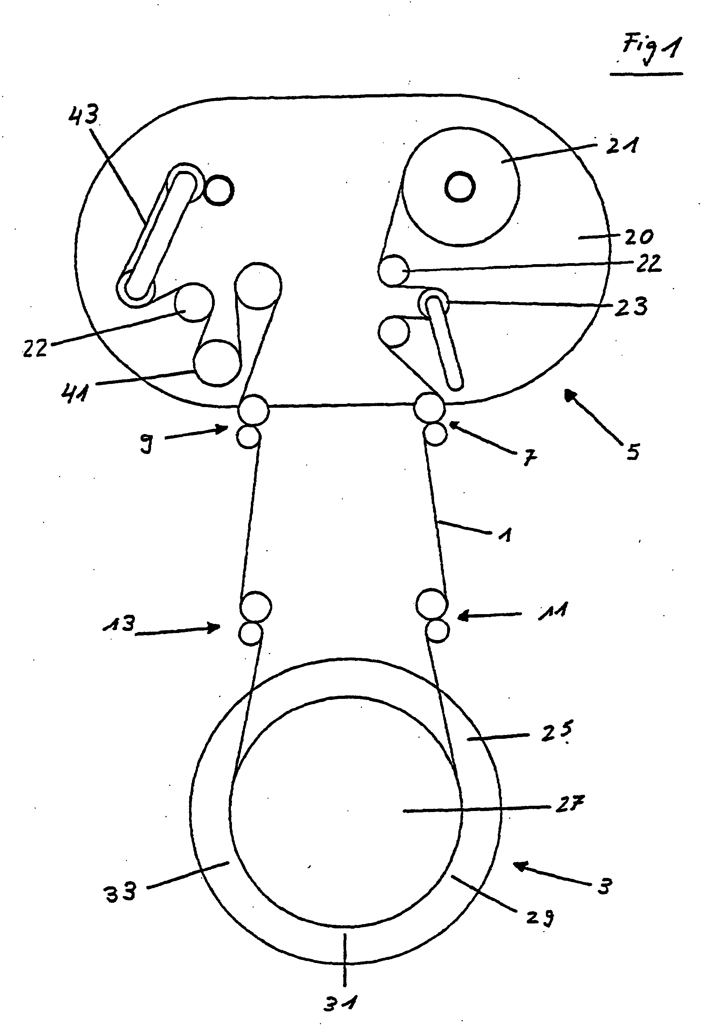

Fig. 1 und 2 zeigen schematisch eine erfindungsgemässe Vakuumbehandlungsanlage für die Oberflächenbehandlung und/oder-beschichtung eines bandförmigen Substrates bzw. einer längsausgedehnten Bandfolie 1. Das bandförmige Substrat wird dabei in einer Vorrats- und Wickelkammer 20 von einer Vorratsrolle 21 abgezogen und über Umlenkrollen 22, und Spannrollen 23 und durch eine erste Walzendichtung 7 aus der Vorrats- und Wickelkammer 20 abgezogen. Ober eine weitere Walzendichtung 11 wird das bandförmige Substrat in eine Vakuumbehandlungsanlage 3 eingeführt, aufweisend eine evakuierbare Reaktionskammer 25 und eine Bearbeitungs- bzw. Behandlungstrommel 27, um weiche herum das bandförmige Substrat 1 geführt wird. Entlang des um die Trommel 27 herum geführten Weges kann das bandförmige Substrat an Öffnungen 29, 31 und 33 verschiedenen Beschichtungs- bzw. Behandlungsoperationen unterzogen werden.

Nach Beendigung der Oberflächenbehandlung bzw. -beschichtung wird das bandförmige Substrat 1 erneut über eine weitere Walzendichtung 13 aus der Vakuumbearbeitungsanlage 3 abgezogen und nach einer Oberflächen-Nachbehandlung über eine vierte Walzendichtung 9 erneut in die Wickel- bzw. Vorratskammer 20 eingeführt, um über weitere Umlenk- 22 bzw. Spannrolien 41 einer Aufwickelvorrichtung 43 zugeführt zu werden.

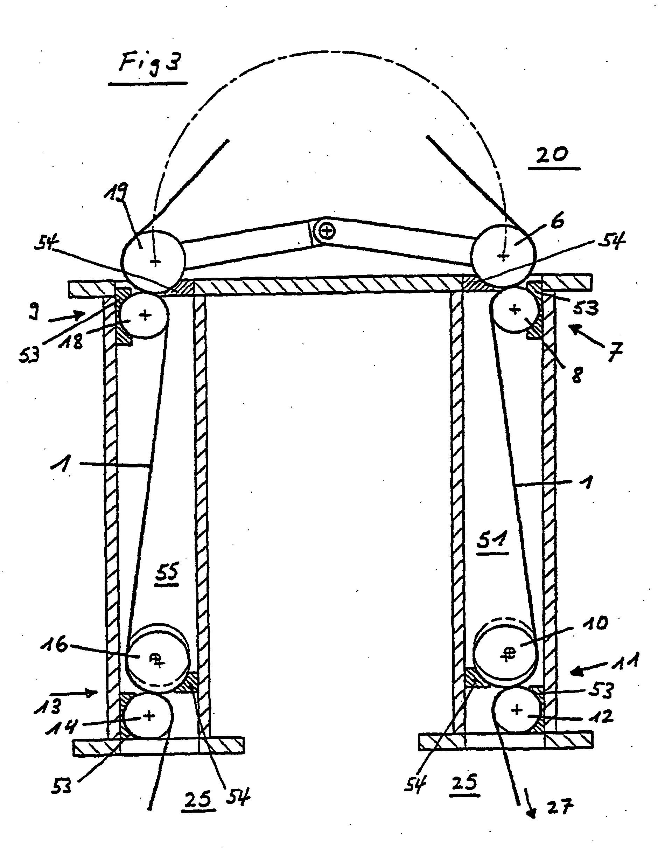

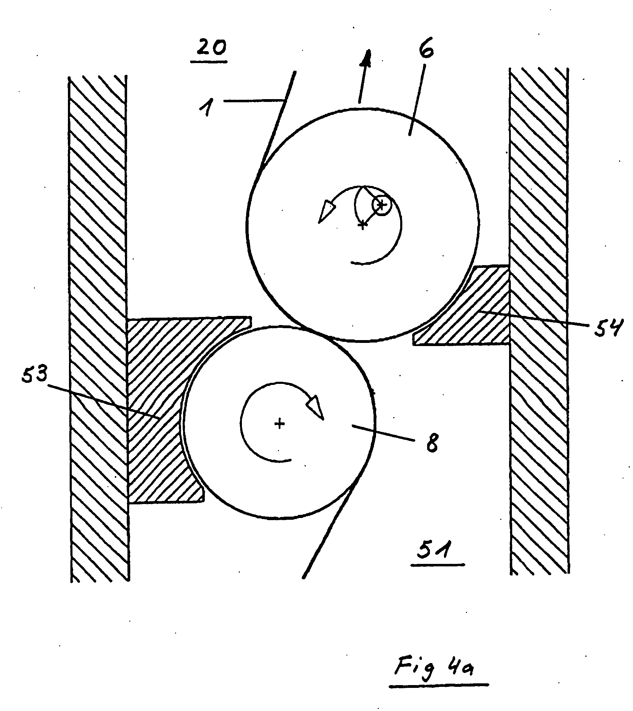

Erfindungsgemäss sind zwischen der Vorrats- und Wickelkammer 20 und der Reaktionskammer 25 Schleusenkammern anzuordnen, wie schematisch in Fig. 3 dargestellt. Dabei zeigt Fig. 3 den Ausschnitt der Anlage aus den Fig. 1 und 2 zwischen der Vorrats- und Wickelkammer 20 einerseits und andererseits der Reaktionskammer 25. Das bandförmige Substrat wird aus der Vorrats- und Wickelkammer 20 über eine erste Walzendichtung 7, umfassend die beiden Walzen 6 und 8, in die erste Schleusenkammer 51 eingeführt. Dabei ist die eine Walze 6 gegen die andere Walze 8 oder gegen eine Abdichtungsvorrichtung vorgespannt angeordnet, um je nach Banddicke des bandförmigen Substrates 1 immer eine ausreichende Dichtung zwischen der Vorrats- und Wickelkammer 20 und der ersten Schleusenkammer 51 zu garantieren. Im weiteren werden die beiden Walzen 6 und 8 je gegen Wandungen der beiden Kammern mit minimalem Spalt, der einstellbar ist und wenige Zehntelsmillimeter beträgt, angeordnet, wobei die Wandungen in diesem Bereich, wie vorliegend im Bereich von Dichtungsbacken 53, 54 in der ersten Schleusenkammer 51, mit einer hochabriebfesten, gut gleitenden Beschichtung, wie beispielsweise Teflon, versehen sind. Ebenfalls die Oberflächen der beiden Walzen 6 und 8 können mit einem derartigen Material versehen bzw. beschichtet sein, wie beispielsweise Viton oder Teflon. Wichtig ist ja, dass zwischen den beiden Kammern 20,51 eine möglichst hohe Dichtwirkung erzielt werden kann, um einerseits die Druckunterschiede zwischen den beiden Kammern aufrechtzuerhalten und um anderseits zu verhindern, dass ein Gasaustausch zwischen den beiden

Kammern stattfindet.

Am Ende der ersten Schleusenkammer 51 wird das bandförmige Substrat 1 über eine zweite Walzendichtung 11, bestehend aus den beiden Wälzen 10 und 12 mit Dichtungsbacken 53,54, in die Reaktionskammer 25 eingeführt, um auf die Bearbeitungs- bzw. Reaktionstrommel 27 (Fig.1,2) zu gelangen. Auch bei der zweiten Walzenschleuse 11 gelten dieselben Anforderungen in bezug auf Dichtheit, so dass möglichst wenig bis gar keine Reaktionsgase aus dem Reaktionsraum 25 in die erste Schleusenkammer 51 und umgekehrt gelangen können.

Analog dem Reaktionsraum 25 nachgeschaltet ist eine zweite Schleusenkammer 55, in welche das bandförmige Substrat 1 über eine dritte Walzendichtung 13, bestehend aus zwei Walzen 14 und 16 mit Dichtungsbacken (53,54), geführt wird. Uber eine vierte Walzendichtung 9 schliesslich, bestehend aus zwei Walzen 18 und 19, wird das bandförmige Substrat 1 erneut in die Vorrats- und Wickelkammer 20 geleitet, um auf der Wickelvorrichtung 43 aufgewickelt zu werden. Im Berührungsbereich der Walze 18 und evt. 19 und der Wandung der zweiten Schleusenkammer 55 ist wiederum eine Walzendichtung vorgesehen, welchereicht neltlar- zusätzlich mit einer hochabriebfesten, gut gleitenden Beschichtung, wie beispielsweise Teflon vesehen ist.

Ein Vorteil des erfindungsgemässen Anordnens der beiden Schleusenkammern 51 und 55, wie in Fig. 3 dargestellt, liegt nun darin, dass die Vorrats- und Wickelkammer 20 mit zumindest ausreichender Abdichtung von der Reaktionskammer 25 abgetrennt ist. Somit kann einerseits die Gefahr vermieden werden, dass Reaktionsgase aus dem Reaktionsraum 25 in die Vorrats- und Wickelkammer 20 gelangen können, und andererseits können sowohl der Vorrat an unbehamdeltem bandförmigem Substrat 21 wie auch die Wickelvorrichtung 43 jederzeit ersetzt bzw. entfernt werden, ohne dass die Reaktionskammer zu öffnen ist. Dies geschieht insbesondere derart, dass vor vollständigem Abrollen des bandförmigen Substrates 1 von der Vorratsrolle 21 diese ersetzt und ein neues bandförmiges Substrat eingesetzt wird und der Anfang des neuen Substrates mit dem Ende des vorhergehenden bandförmigen Substrates verbunden wird und so ein "Einfädeln" des neuen Substrates unnötig wird. Auch kann auf diese Art und Weise praktisch kontinuierlich gearbeitet werden.

Ein weiterer Vorteil des Anordnens der beiden Schleusenkammern 51,55 liegt darin, dass in diesen Schleusenkammern weitere Bearbeitungsprozesse, wie beispielsweise das Vorbehandeln des noch nicht behandelten Substrates in der vorgeschalteten Schleusenkammer 51 möglich ist, wie Trocknen oder Reinigen, Oberflächenaktivieren, Beschichten mit Nicht-Plasma-Prozessen, wie UV-Polymerisation usw., während in der nachgeschalteten Schleusenkammer 55 das bereits behandelte Substrat nachbehandelt werden kann, wie beispielsweise Plasmapfropfen, Fixieren einer Beschichtung, Modifizieren, Beschichten mit Nicht-Plasma-Prozessen etc. Auch ist es möglich, diese beiden Kammern zu evakuieren, mit Stickstoffatmosphären zu versehen etc. Selbstverständlich besteht auch hier die Möglichkeit bei Bedarf ebenfalls mindestens eine Elektronenquelle entsprechend der in der Beschreibungseinleitung angeführten Liste bzw. eine Plasmaquelle anzuschliessen und PVD- und/oder PE-CVD-Prozesse durchzuführen.

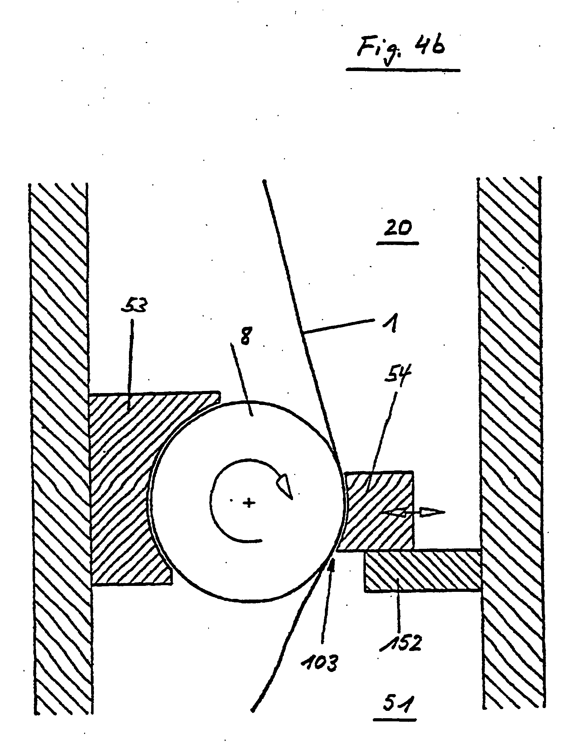

Fig. 4a zeigt die Walzendichtung 7 aus Fig. 3, aufweisend die beiden Walzen bzw. Rollen 6 und 8, wobei die Walzendichtung 7 gegen das Innere des Schleusenkammer 51 verschoßen ist und das fußstratband 1 in umgebelrter Richtung zwischen den Walzen 6 und 8 durchläuft. Dabei ist die Walze 6 wegschwenkbar angeordnet, beispielsweise, um das Substrat bzw. die zu beschichtende Folie 1 "einfädeln" zu können. Weiter ist es möglich, dass beispielsweise Walze 6 gegen die Rolle 8 vorgespannt angeordnet ist, um einen gewissen Anpressdruck zwischen den beiden Walzen zu erzeugen, um so die Dichtigkeit zwischen den beiden Kammern 20 und 51 zu erhöhen.

Im Bereich der Wandungen sind Dichtungsbacken 53 und 54 vorgesehen, welche nur um einen äusserst geringen Spalt von den beiden Rollen bzw. Walzen 19 und 18 beabstandet sind. Der Spalt soll nur wenige Zehntelmillimeter betragen, so dass Druckunterschiede in den Kammern 20 und 55 aufrechterhalten bleiben, resp. weitgehendst kein Gasaustausch zwischen den beiden Kammern 20 und 55 stattfinden kann.

Demgegenüber zeigt Fig. 4b eine Ausführungsvariante einer Walzendichtung, lediglich aufweisend eine einzige Walze 8. Wiederum ist diese Walzenschleuse 5 beispielsweise zwischen einer Vorrats- und Wickelkammer 20 und einer ersten Schleusenkammer 51 angeordnet, durch welche hindurch das zu beschichtende bzw. zu behandelnde Substrat 1 geführt wird. Gegenüber den beiden Kammerwandungen sind wiederum Abdichtungsvorrichtungen vorgesehen, um sicherzustellen, dass Druckunterschiede zwischen den beiden Kammern 20 und 51 aufrechterhalten bleiben. Die eine Abdichtungsvorrichtung weist einerseits eine Basis 152 auf, auf welcher eine wegschiebbare Dichtungsbacke 54 angeordnet ist. Analog weist die andere Abdichtungsvorrichtung an der anderen Kammerwandung eine Dichtungsbacke 53 auf, welcher starr mit der Wandung verbunden ist. Die Schleusenanordnung ist nun derart dimensioniert, dass jeweils zwischen den Dichtungsbacken 53 und 54 und der Walze 8 ein minimaler Spalt entsteht, in der Grössenordnung von höchstens wenigen Zehntelmillimetern Spaltbreite. Die Dichtungsbacke 54 ist deshalb wegschiebbar ausgebildet, damit das Substrat and 1 durch den Spalt 103 hindurch "eingefädelt" werden kann.

Sowohl die Walzenoberflächen der Walzen 6 und 8 als auch die den Walzen zugewandten Oberflächen der Dichtungsbacken 53, 54 können mit einer hochabriebfesten, gut gleitenden Beschichtung versehen sein, wie beispielsweise bestehend aus Viton oder Teflon. Dies ist insbesondere dann wichtig, wenn die zwischen Dichtungsbacken 53,54 und Walzen herrschenden Spaltbreiten minimalst sind und gegebenenfalls die Gefahr der Berührung besteht.

Selbstverständlich handelt es sich bei den in den Fig. 4a und 4b dargestellten Walzendichtungen nur um Beispiele, welche zum besseren Verständnis der vorliegenden Erfindung dienen. Selbstverständlich ist es auch möglich, Walzendichtungen vorzusehen mit mehr als zwei Walzen, um gegebenenfalls die Dichtung zwischen den mit der Schleuse verbundenen Kammern zu erhöhen.

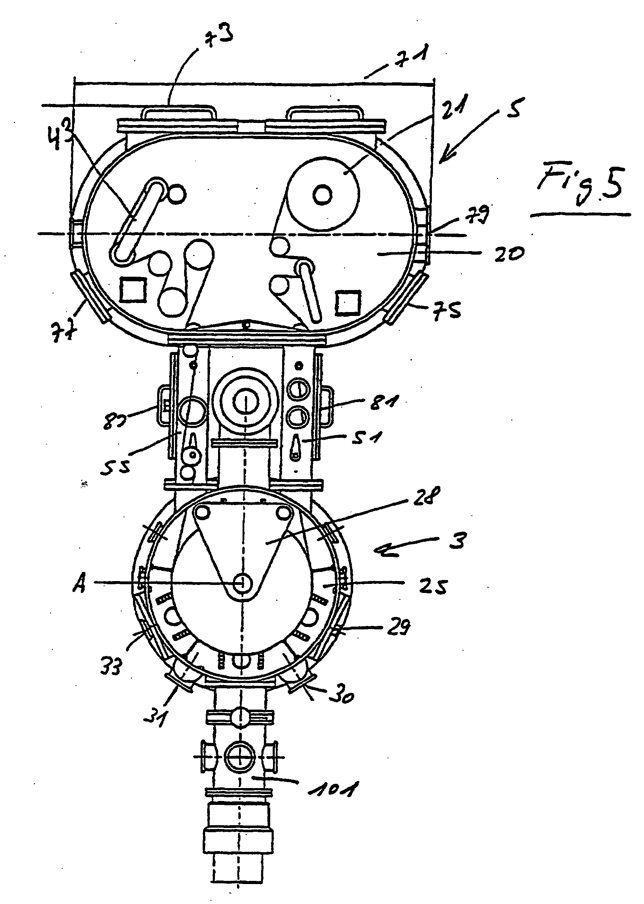

In Fig. 5 ist schematisch eine praxisnahe Anlage dargestellt, welche in etwa dem Aufbau der Schematas, dargestellt in den Fig. 1 bis 3, entspricht. Aus diesem Grunde wird auf eine erneute detaillierte Beschreibung der Anlage, dargestellt in Fig. 5, verzichtet.

An der Vorrats- bzw. Wickelvorrichtung 5, aufweisend die evakuierbare Vorrats- und Nickelkammer 20, sind zunächst Öffnungen 71 und 73 erkennbar, durch welche hindurch einerseits die Vorratsrolle 21 ausgewechselt werden kann, wie andererseits die Wickelvorrichtung 43. Für das Überwachen der Funktionsweise sind weiter zwei fensterartige Öffnungen 75 und 77 erkennbar, währenddem schliesslich über einen Anschlussstutzen 79 die Vorrats- und Wickelkammer 20 evakuierbar ist.

Auch an den beiden Schleusenkammern 51 und 55 sind wiederverschliessbare Öffnungen 81 und 83 vorgesehen, um jederzeit die Schleusenkammern öffnen zu können. Weitere Öffnungen, wie beispielsweise fensterartige Öffnungen, Anschlussstutzen für das Anlegen eines Vakuums etc. sind möglich, jedoch wird auf eine detaillierte Beschreibung derselben verzichtet. An der evakuierbaren Reaktionskammer 25 sind erneut Öffnungen 29,30,31,33 vorgesehen, beispielsweise für das Anordnen von Bearbeitungseinrichtungen bzw. Plasmaquellen, für das Durchführen verschiedener Bearbeitungsprozesse. Die Reaktionskammer 25 schliesslich kann über einen Anschlussstutzen 101 evakuiert werden. Das Achslager 28 mit der Achse A für die Trommel 27 ist im wesentlichen dreieckförmig ausgebildet.

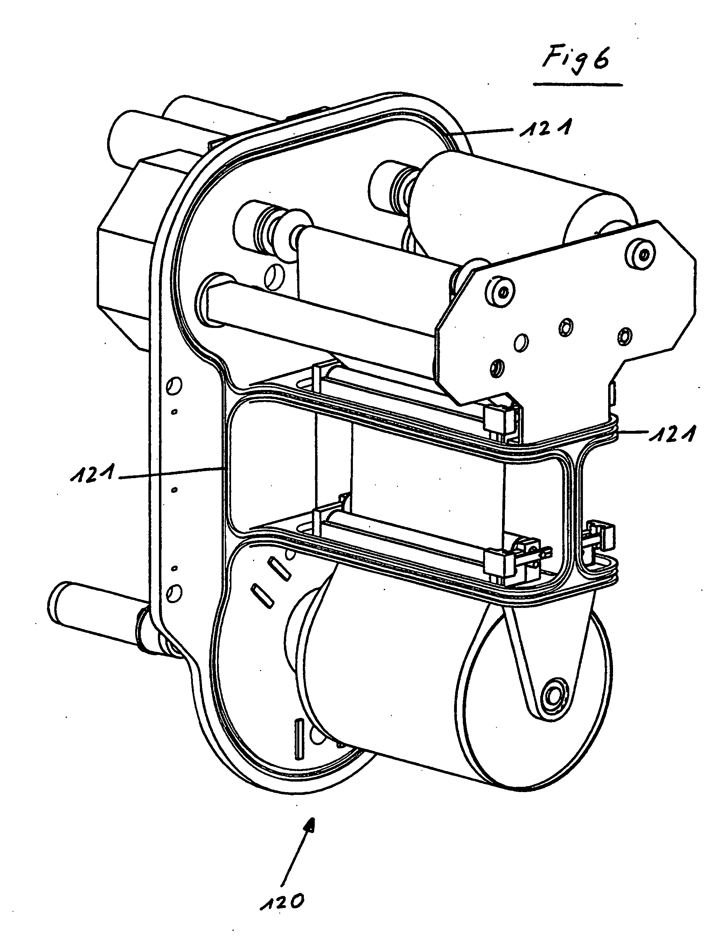

Fig. 6 schliesslich zeigt in analoger Art und Weise wie in Fig. 2 dargestellt, eine ähnliche Vakuumbandbeschichtungsanlage, jedoch aufweisend Dichtungen 121, um das ganze, in Fig. 6 perspektivisch dargestellte, Anlageteil 120 oder Teile davon austauschbar in einer Vakuumbehandlungsanlage einzuführen bzw. wieder zu entfernen. So kann beispielsweise das in Fig. 6 dargestellte Anlageteil 120 in ein entsprechendes, für das Durchführen der diversen Bearbeitungsprozesse ausgelegtes Gehäuseteil (nicht dargestellt) als Modul eingeführt werden zur Durchführung dieser Behandlungsprozesse. Nach erfolgter Behandlung eines auf dem Anlageteil 120 angeordneten Substrates wird das Anlageteil aus dem erwähnten Gehäuseteil entfernt und kann bei

Bedarf durch ein anderes Anlageteil ersetzt werden, auf welchem ein anderes zu behandelndes Substrat angeordnet ist.

Zusammenfassend bestehen die in den Fig. 1 bis 6 dargestellten Vakuumanlage aus mindestens vier Kammern 20,51,25,55, welche miteinander so verbunden sind, dass nur ein minimaler Austausch von Gasen zwischen den Kammern stattfinden kann. Über die dargestellten Walzendichtungen 7,11;9,13 werden die Bandmaterialien (Folien und Bänder aus Kunststoff, Papier etc. oder Vliesen Textilien etc.) von einer Kammer in die andere transportiert. Die Vakuumanlagen bestehen aus einer oder mehreren Vorrats- und Wickelkammer(-n) 20, zwei Schleusenkammern 51, 55 und einer Reaktionskammer 25. In der Vorrats- und Wickelkammer 20 wird das bandförmige Substrats auf- und abgewickelt. In den Schleusenkammern 51,55 werden die Materialien physikalisch oder chemisch vor- und nachbehandelt. Die Plasmaprozesse finden vorzugsweise in der Reaktionskammer 25 statt.

Der minimale Gasaustausch zwischen den Kammern 20,51,25,55 hat mehrere Vorteile. Eine Oberflächenreaktion findet vorwiegend dort statt, wo sie erwünscht ist. So werden die Rollen in der VorratsWickelkammer 20 nicht auch noch beschichtet. Zudem können erhebliche Druckunterschiede zwischen den einzelnen Kammern aufrechterhalten werden.

Die Verfahren der Plasmatechnik können durch die vorliegende Kammerkonzeption mit komplementierenden Verfahren in den Schleusenkammern ergänzt und erweitert werden. Die Prozesse sind zudem gut definiert und kontrollierbar. Die erschwerte Zugänglichkeit zur Vorrats- und Wickelkammer 20 (Einfädeln des Rollgutes) kann durch Flansche, ausschwenkbare Walzen oder dem herausnehmbaren Anlageteil 120 sichergestellt werden.
1. Vorrats- und Wickelkammer 20:
   In der Vorrats- und Wickelkammer 20 wird die flächige Substratbahn 1 ausgewechselt, vorevakuiert und kann zusätzlich getrocknet werden. Die Substratbahn 1 kann bis zu technisch machbaren Geschwindigkeiten ab- und aufgewickelt werden. Heutzutage wird oft bis zu 500 m/min gewickelt. Die Substratbahn 1 kann aber auch im Tippbetrieb von einer Kammer zur anderen vorwärts oder rückwärts transportiert werden.
2. Erste Schleusenkammer 51 zur Vorbehandlung :
   Mögliche Vorbehandlung: Klassische Nasschemie; Wärme-, UVund Elektronenstrahl-unterstützte chemische Verfahren.
   Arbeitsdruckbereich: 10⁻⁶ mbar bis Atmosphäre.
   Beispiel für Oberflächenreinigungen: In dieser Vakuum-Schleusenkammer kann die Oberfläche von restlichem Wasser durch Infrarot- bzw. Halogenstrahler befreit werden.
   Beispiel für Oberflächenmodifikation: Mit UV-Licht kann z.B. die hydrophobe Oberfläche von Polymermaterialien funktionalisiert, d.h. polar gemacht werden (hohe OberflächenSpannung). Dadurch kann die Haftung der Beschichtung des nachfolgenden Plasmaprozesses erhöht werden.
   Beispiel für Oberflächenbeschichtung: Das Einbringen von Prozessgasen in die Kammer (z.B. Akrylsäure) ermöglicht, die Oberfläche des Substrates vorzubehandeln. Dadurch können Unebenheiten der rauhen Oberfläche ausgeglichen werden.
   Beispiel für Oberflächenbeschichtung: Als weitere Option kann in der Reaktionskammer die auf der Oberfläche haftende Verbindung bzw. Substanz mit einem Plasmaprozess fixiert werden. Dadurch kann z.B. die Oberflächenmorphologie optimiert werden oder die Haftung der nachfolgenden Schicht beeinflusst werden.
3. Reaktionskammer 25:
   In der Vakuumkammer sind mehrere und verschiedene Anregungsquellen anflanschbar. Der Arbeitsdruckbereich beträgt 5 · 10⁻⁷ mbar bis Atmosphäre.
   Mögliche Quellen sind:
   DC-Magnetronzerstäubungsquelle, kontinuierlich und gepulst;
   Hf-Magnetronzerstäubungsquelle, kontinuierlich und gepulst;
   Gleichstrom-Entladung, kontinuierlich und gepulst;
   Niederfrequenz- resp. Tieffrequenz-Entladung, kontinuierlich und gepulst;
   Hochfrequenz-Entladung, kontinuierlich und gepulst;
   Mikrowellen mit und ohne Magnetfeldunterstützung, kontinuierlich und gepulst;
   Radikalgenerator, kontinuierlich und gepulst;
   Elektronenstrahlquelle, kontinuierlich und gepulst;
   Ionenstrahlquelle, kontinuierlich und/oder gepulst;

   Elektronenstrahl- oder Laser-unterstütze Plasmaquelle, kontinuierlich und gepulst.
   Die Substrattrommel 27 kann gekühlt und geheizt werden (-20°C bis +100°C) und ist geerdet oder kann mit einer Bias-Wechselspannung (10kHz bis 200 MHz) oder Gleichstromspannung versehen werden.
   Die Reaktionskammer 25, beispielsweise mit einer Substrattrommel 27 von ⌀ 600 mm, bietet die Möglichkeit, bis zu drei verschiedene Entladungsarten in einem Verfahren zu kombinieren.
   Grössere Trommeln ermöglichen mehr Quellen. Die Plasmaquellen sind mit herausnehmbaren Wänden voneinander getrennt, so dass unterschiedliche Prozessgase eingesetzt werden können.
   Zusätzlich können die verschiedensten Anregungsquellen auf die grossen, z.B. rechteckigen Flansche, angeflanscht werden.
   Beispiel für kombiniertes Plasmaverfahren: Die Polymeroberfläche wird mit einem Hochfrequenzplasma oder Mikrowellenplasma gereinigt und aktiviert. Anschliessend wird die Polymerfolie mit der gepulsten DC-Magnetronzerstäubungsquelle mit einer Diffusionsbarriere beschichtet. Die hydrophobe Barriereschicht wird im Mikrowellenplasma mit einer hauchdünnen polaren Schicht versehen.
   Die Reaktionskammer kann von den Schleusenkammern abgekoppelt werden (Blindflanschen) und als eigenständige Einheit betrieben werden.
   Die Substrattrommel 27 kann dann mit anderen Substraten versehen werden, z.B. Visitenkarten.
4. Zweite Schleusenkammer 55 zur Nachbehandlung :
   Das durch den Plasmaprozess aktivierte oder beschichtete Substrat kann in der zweiten Sehleusenkammer 55 zur Reaktion mit geeignetem Prozessgas gebracht werden. Dieses Verfahren ist in der Literatur als Plasmapfropfen beschrieben. Wie bei der ersten Schleusenkammer 51 zur Vorbehandlung kann der Prozess durch Infrarot-, UV- oder weitere Quellen unterstützt werden. In der zweiten Schleusenkammer 55 ist aber auch die Stabilisierung einer Plasmabeschichtung bzw. eine Trocknung möglich.
   Bei einer in den Fig. 1 bis 6 dargestellten Vakuumbehandlungsanlage wird es möglich, die Anlage sehr platz- bzw. raumsparend auszubilden, während beispielsweise eine längsausgedehnte Anlage, mit in Längsrichtung aneinandergereihten Kammern, wie eingangs im Stand der Technik beschrieben, kein raumsparendes Konzept darstellt.

## Patentansprüche

1. Vakuumbehandlungsanlage (3) zur Oberflächenbehandlung und/oder -beschichtung, insbesondere zur Abscheidung von plasmapolymerisierten Schichten, für kontinuierlich durchlaufendes Bandmaterial (1), weiche Anlage (3) wenigstens je eine Vorratskammer zum Abwickeln des flächigen, unbehandelten Bandmaterials (1), eine Reaktionskammer (25) zum Behandeln, Bearbeiten oder Beschichten des umlaufenden Bandmaterials (1) und eine Wickelkammer zum Aufwickeln des behandelten Bandmaterials (1) umfasst, wobei die Vorrats- und Wickelkammer/n Mittel zum Abdichten von der betreffenden Reaktionskammer (25) hat/haben,
**dadurch gekennzeichnet, dass**
in der Anlage (3) wenigstens eine gemeinsame Vorrats- und Wickelkammer (20), ausgebildet ist, und als Mittel zum Aufrechterhalten des Druckunterschiedes und zur Verhinderung eines Gasaustausches zwischen den beiden Kammern (20,25) je eine der Vorrats- und Wickelkammer (20) bezüglich des durchlaufenden Bandmaterials (1) nach- und vorgeschaltete, evakuierbare Schleusenkammer (51,55) mit beidends wenigstens eine Walze (6,8;10,12;14,16;18,19) umfassenden Walzendichtungen (7,11;9,13) ausgebildet sind, wobei die Walzen (6,8; 10,12; 14,16; 18,19) wenigstens teilweise verschiebbar oder schwenkbar ausgebildet sind.

2. Anlage (3) nach Anspruch 1, **dadurch gekennzeichnet, dass** die Walzen (6,8,10,12,14,16,18, 19) gegen zwei Dichtungsbacken (53,54) anstellbar oder auf einen minimierbaren Abstand von wenigen Zehntelsmillimetern einstellbar sind.

3. Anlage (3) nach Anspruch 2, **dadurch gekennzeichnet, dass** die Dichtungsbacken (53,54) einen der zugeordneten Walzenoberfläche entsprechenden Innenradius haben.

4. Anlage (3) nach einem der Ansprüche 1 bis 3, **dadurch gekennzeichnet, dass** die Walzen (6,8,10,12,14,16,18,19) und/oder die Dichtungsbacken (53,54) wenigstens teilweise mit einer hochabriebfesten, gleitenden Beschichtung ausgerüstet sind, vorzugsweise aus Tetrafluoräthylen.

5. Anlage (3) nach einem der Ansprüche 1 bis 4, **dadurch gekennzeichnet, dass** die Schleusenkammern (51,55) stimseitig je ein Walzenpaar (6,8; 10,12; 14,16; 18,19) mit dazwischen durchlaufendem Bandmaterial (1) umfassen, wobei diese Walzendichtungen einstellbar sind.

6. Anlage (3) nach einem der Ansprüche 1 bis 5, **dadurch gekennzeichnet, dass** in der Reaktionskammer (25) mindestens eine Bearbeitungstrommel (27) für das durchlaufende flächige Bandmaterial (1) angeordnet ist.

7. Anlage (3) nach Anspruch 6, **dadurch gekennzeichnet, dass** die Reaktionskammer (25) wenigstens eine Einrichtung (29,30,31,33) der Gruppe bestehend aus
- DC-Magnetronzerstäubungsquelle
- HF-Magnetronzerstäubungsquelle
- Gleichstromentladung
- Niederfrequenz-Entladung
- Hochfrequenz-Entladung
- Mikrowellen mit und ohne Magnetfeldunterstützung
- Radikalgenerator
- Elektronenstrahlquelle
- Ionenstrahiquelle
- Elektronenstrahl- oder laserunterstützte Plasmaquelle
umfasst, jeweils kontinuierlich und/oder gepulst.

8. Anlage (3) nach einem der Ansprüche 6 oder 7, **dadurch gekennzeichnet, dass** die Bearbeitungstrommel (27) kühlbar, beheizbar, geerdet und/oder mit einem Bias versehen ist.

9. Anlage (3) nach einem der Ansprüche 1 bis 8, **dadurch gekennzeichnet, dass** wenigstens eine der Schleusenkammern (51, 55) eine Behandlungseinrichtung für die Vorbehandlung des unbehandelten oder zur Nachbehandlung des behandelten flächigen Bandmaterials (1) umfasst.

10. Anlage (3) nach einem der Ansprüche 2 bis 9, **dadurch gekennzeichnet, dass** die verschiebbare oder schwenkbare Walze eines Walzenpaares gegenüber der anderen Walze vorgespannt angeordnet ist.

11. Anlage (3) nach einem der Ansprüche 2 bis 10, **dadurch gekennzeichnet, dass** wenigstens eine der Dichtungsbacken (53, 54) einstellbar ist.

12. Anlage (3) nach einem der Ansprüche 1 bis 11, **dadurch gekennzeichnet, dass** die Vorrats- und Wickelkammer/n (20), die Schleusenkammern (51, 55) und die Reaktionskammer/n (25) als Einbaumodul (120) ausgebildet sind, wobei auch Teile davon auswechselbar sind.

13. Anlage (3) nach Anspruch 12, **dadurch gekennzeichnet, dass** am Einbaumodul (120) peripher umlaufende Dichtungsmittel (121) angeordnet sind.

14. Anlage (3) nach einem der Ansprüche 1 bis 13, **dadurch gekennzeichnet, dass** das flächige Bandmaterial (1) aus einem Polymer, Metall, Papier, aus kombinierten Werkstoffen, insbesondere Kompositwerkstoffen und/oder mehrlagigen Werkstoffen, wie metallisiertem Material, besteht.

15. Verwendung einer Vakuumbehandlungsanlage (3) nach einem der Ansprüche 1 bis 14 für die Oberflächenbehandlung von Verpackungsmaterialien (1), insbesondere für Lebensmittel, Medikamente, Tabak und Elektronikkomponenten.

## Claims

1. Vacuum treatment plant (3) for surface treatment and/or coating, in particular for deposition of plasma-polymerised layers, for continuously moving strip material (1), which plant (3) has at least one storage chamber for unwinding the flat untreated strip material (1), a reaction chamber (25) for processing, treating or coating the circulating strip material (1) and a winding chamber for winding the treated strip material (1), where the storage and winding chambers have means for sealing the reaction chambers (25) concerned, **characterised in that** in the plant (3) is formed at least one common winding and storage chamber (20) and, as means for maintaining the pressure difference and preventing gas exchange between the two chambers (20, 25), before and after the storage and winding chamber (20) in relation to the moving strip material (1) are arranged evacuable transfer chambers (51, 55) with at both ends roller seals (7, 11; 9, 13) comprising at least one roller (6, 8; 10, 12; 14, 16; 18, 19), where the rollers (6, 8; 10, 12; 14, 16; 18, 19) are designed to be at least partly moveable or swivellable.

2. Plant (3) according to claim 1, **characterised in that** the rollers (6, 8; 10, 12; 14, 16; 18, 19) can be placed against two sealing jaws (53, 54) or set at a minimum spacing of a few tenths of millimetres therefrom.

3. Plant (3) according to claim 2, **characterised in that** the sealing jaws (53, 54) have an inner radius corresponding to the allocated roller surface.

4. Plant (3) according to any of claims 1 to 3, **characterised in that** the rollers (6, 8; 10, 12; 14, 16; 18, 19) and/or the sealing jaws (53, 54) are fitted at least partly with a highly abrasion-resistant, slippery coating, preferably of tetrafluoroethylene.

5. Plant (3) according to any of claims 1 to 4, **characterised in that** the transfer chambers (51, 55) each have on the front a roller pair (6, 8; 10, 12; 14, 16; 18, 19) with the strip material (1) running in between, where these roller seals are adjustable.

6. Plant (3) according to any of claims 1 to 5, **characterised in that** arranged in the reaction chamber (25) is at least one processing drum (27) for the flat strip material (1).

7. Plant (3) according to claim 6, **characterised in that** the reaction chamber (25) comprises at least one device (29, 30, 31, 33) of the group comprising:
- DC magnetron atomisation source
- HF magnetron atomisation source
- DC discharge
- Low frequency discharge
- High frequency discharge
- Microwave with and without magnetic field support
- Radical generator
- Electron beam source
- Ion beam source
- Electron beam- or laser-supported plasma source each continuous and/or pulsed.

8. Plant (3) according to any of claims 6 or 7, **characterised in that** the processing drum (27) can be cooled, heated, earthed and/or given a bias.

9. Plant (3) according to any of claims 1 to 8, **characterised in that** at least one of the transfer chambers (51, 55) comprises a treatment device for pretreatment of the untreated, or post-treatment of the treated, flat strip material (1).

10. Plant (3) according to any of claims 2 to 9, **characterised in that** the moveable or swivellable roller of a roller pair is arranged pretensioned against the other roller.

11. Plant (3) according to any of claims 2 to 10, **characterised in that** at least one of the sealing jaws (53, 54) is adjustable.

12. Plant (3) according to any of claims 1 to 11, **characterised in that** the storage and winding chamber(s) (20), the transfer chambers (51, 55) and the reaction chamber(s) (25) are formed as an insert module (120), where parts thereof are also exchangeable.

13. Plant (3) according to claim 12, **characterised in that** arranged round the periphery of the insert module (120) are sealing means (121).

14. Plant (3) according to any of claims 1 to 13, **characterised in that** the flat strip material (1) comprises a polymer, metal, paper, combined material, in particular composite materials and/or laminate materials such as metallised material.

15. Use of a vacuum treatment plant (3) according to any of claims 1 to 14, for the surface treatment of packing materials (1) in particular for foodstuffs, medicaments, tobacco and electronic components.

## Revendications

1. Installation (3) de traitement sous vide d'une matière en bande (1) passant en continu, pour la traiter et/ou le revêtir en surface, en particulier pour y déposer des couches polymérisées par plasma, installation (3) qui comprend au moins respectivement une chambre de dérouleur pour dérouler la matière en bande plate non traitée (1), une chambre de réaction (25) pour préparer, traiter ou revêtir la matière en bande qui circule (1) et une chambre d'enrouleur pour enrouler la matière en bande traitée (1), dans laquelle la chambre ou les chambres de dérouleur et d'enrouleur comprend ou comprennent des moyens d'étanchéité vis-à-vis de la chambre de réaction correspondante (25),
**caractérisée en ce que**
l'installation (3) comprend au moins une chambre commune de dérouleur et d'enrouleur (20), et **en ce que** des chambres de sas (51, 55) qui peuvent être mises en dépression et comportent des joints d'étanchéité (7, 11; 9, 13) à cylindres incluant chacun à ses deux extrémités au moins un cylindre (6, 8; 10, 12; 14, 16; 18, 19) sont montées respectivement en aval et en amont de la chambre de dérouleur et d'enrouleur (20), par rapport à la direction de circulation de la matière en bande, comme moyens destinés à maintenir la différence de pression et à empêcher un échange de gaz entre les deux chambres (20, 25), la structure des cylindres (6, 8; 10, 12; 14, 16; 18, 19) permettant leur glissement ou leur pivotement au moins partiel.

2. Installation (3) selon la revendication 1, **caractérisée en ce que** les cylindres (6, 8; 10, 12; 14, 16; 18, 19) peuvent être serrés contre deux joues (53, 54) de joints d'étanchéité ou être montés à une distance, qui peut être minimisée, de quelques dixièmes de millimètre de ceux-ci.

3. Installation (3) selon la revendication 2, **caractérisée en ce que** les rayons intérieurs des joues (53, 54) des joints d'étanchéité correspondent à la surface associée des cylindres.

4. Installation (3) selon l'une quelconque des revendications précédentes, **caractérisée en ce que** les cylindres (6, 8; 10, 12; 14, 16; 18, 19) et/ou les joues (53, 54) des joints d'étanchéité comportent au moins en partie un revêtement glissant à haute résistance à l'abrasion, de préférence en tétrafluoréthylène.

5. Installation (3) selon l'une quelconque des revendications précédentes, **caractérisée en ce que** chacune des parties frontales des chambres de sas (51, 55) comporte une paire de cylindres (6, 8; 10, 12; 14, 16; 18, 19) entre lesquels circule la matière en bande (1), ces joints d'étanchéité à cylindres étant ajustables.

6. Installation (3) selon l'une quelconque des revendications précédentes, **caractérisée en ce qu'**au moins un tambour de traitement (27) est agencé dans la chambre de réaction (25) pour la matière en bande plate (1) en circulation

7. Installation (3) selon la revendication 6, **caractérisée en ce que** la chambre de réaction (25) comporte au moins un dispositif (29, 30, 31, 33), fonctionnant en continu et/ou par impulsions, du groupe constitué par
- une source de pulvérisation à magnétron en courant continu
- une source de pulvérisation à magnétron à haute fréquence
- une décharge en courant continu
- une décharge à basse fréquence
- une décharge à haute fréquence
- des micro-ondes, assistées ou non par champs magnétiques
- un générateur de radicaux
- une source de rayonnement électronique
- une source de rayonnement ionique
- une source de plasma assistée par rayonnement électronique et/ou par laser.

8. Installation (3) selon la revendication 6 ou 7, **caractérisée en ce que** le tambour de transformation (27) peut être refroidi, chauffé, mis à la terre et/ou qu'une polarisation peut lui être appliquée.

9. Installation (3) selon l'une quelconque des revendications précédentes, **caractérisée en ce qu'**au moins l'une des chambres de sas (51, 55) comprend un dispositif de traitement pour appliquer à la matière en bande plate (1) un traitement préalable avant traitement ou un traitement final après traitement.

10. Installation (3) selon l'une quelconque des revendications 2 à 9, **caractérisée en ce que** le cylindre mobile à glissement ou à pivotement d'une paire de cylindres est monté précontraint par rapport à l'autre cylindre.

11. Installation (3) selon l'une quelconque des revendications 2 à 10, **caractérisée en ce qu'**au moins l'une des joues des joints d'étanchéité (53, 54) peut être ajustée.

12. Installation (3) selon l'une quelconque des revendications précédentes, **caractérisée en ce que** la ou les chambre(s) de dérouleur et d'enrouleur (20), les chambres de sas (51, 55) et la ou les chambre(s) de réaction (25) constituent un module encastrable (120), dont certains éléments sont de plus échangeables.

13. Installation (3) selon la revendication 12, **caractérisée en ce que** des moyens de joints d'étanchéité (121) sont montés sur le module encastrable (120) en l'entourant en périphérie.

14. Installation (3) selon l'une quelconque des revendications précédentes, **caractérisée en ce que** la matière plate en bande (1) se compose d'un polymère, d'un métal, d'un papier, de matériaux combinés, en particulier de matériaux composites et/ou de matériaux en couches multiples, comme une matière métallisée.

15. Utilisation d'une installation de traitement sous vide (3) selon l'une quelconque des revendications précédentes, pour le traitement de surface de matières d'emballage (1), en particulier pour les produits alimentaires, les médicaments, le tabac et les composants électroniques.
